(19)

Europäisches
Patentamt
European
Patent Office
Office européen
des brevets

(11) **EP 2 442 242 A1**

(12) **EUROPEAN PATENT APPLICATION**

(43) Date of publication:
**18.04.2012 Bulletin 2012/16**

(51) Int Cl.:
*G06F 17/30* (2006.01)　　　*G06Q 10/00* (2012.01)

(21) Application number: **11181574.2**

(22) Date of filing: **16.09.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **13.10.2010　JP 2010230169**

(71) Applicant: **Fujitsu Limited
Kawasaki-shi, Kanagawa 211-8588 (JP)**

(72) Inventors:
• **Tanabe, Misako
  Kanagawa, 211-8588 (JP)**
• **Moriizumi, Kiyokazu
  Kanagawa, 211-8588 (JP)**
• **Yabumoto, Minoru
  Kanagawa, 211-8588 (JP)**

(74) Representative: **HOFFMANN EITLE
Patent- und Rechtsanwälte
Arabellastraße 4
81925 München (DE)**

(54) **Part information providing system, part information providing apparatus, and part information providing program**

(57)　　The part information providing system includes a part information database (20), a retrieving section (11), and a notifying section (17). The part information database (20) stores part information including a price of a first part and identification information of a second part, which serves as a substitute for the first part and which is cheaper in price than the first part, in association with identification of the first part. The retrieving section (11) retrieves identification information of a third part, which is a component of a device, from the part information database and, if the identification information of the third part is associated with the identification information of the second part, retrieves the second part, which serves as a substitute for the third part and which is cheaper in price than the third part, from the part information database (20) using the identification information of the second part by following a link of the identification information of the second part. The notifying section (17) notifies a user of information about the second part retrieved by the retrieving section (11).

FIG. 1

## Description

FIELD

The embodiment discussed herein is a part information providing program that provides a user with part information, a part information providing apparatus, and a part information providing program (for US a non-transitory computer-readable recording medium in which a part information providing program is stored).

BACKGROUND

Devices, such as computers and mobile phones, consist of a large number of component parts including electric circuit part exemplified by LSI (Large Scale Integration) chips. For designing such a device, a list of parts constituting the device is prepared. The list includes cost information (such as a purchase price) of each component part selected for the device. Aiming at cost reduction of the device, the designer refers to the above list and manually searches for parts (hereinafter called substitute parts) that serve as the same function as respective corresponding component parts and that are cheaper in price than the corresponding component parts. If a substitute part is found through the search, the designer replaces the component part with the found substitute part in the list.

Such a substitute part is searched by each individual designer or each individual department that the designer belongs, so that information about substitute parts obtained through searching are not shared by different designers and designing departments. Therefore, device designers and design departments redundantly search for substitute parts.

If a component part is replaced with a corresponding substitute part found in the above search, the designer of the device manually calculates cost-reduction effect caused by the replacement with the substitute part. Here, cost-reduction effect is, for example, a price difference of the price of a component part and the price of a corresponding substitute part, a price difference of a single device obtained by replacing component parts with substitute parts (i.e., the price difference between before and after the replacement), and an amount of lifetime cost reduction obtained by the replacement.

[Patent Literature 1] Japanese Laid-Open Patent Publication No. 2000-113051
[Patent Literature 2] Japanese Laid-Open Patent Publication No.2001-229193
[Patent Literature 3] Japanese Laid-Open Patent Publication No. HEI 5-266106
[Patent Literature 4] Japanese Laid-Open Patent Publication No.2004-234399
[Patent Literature 5] Japanese Laid-Open Patent Publication No.2004-287951

As described above, since a substitute part is manually searched and is redundantly searched by individual designers and design departments, the search requires a large amount of labor and is not efficient. In addition, cost-reduction effect resulting from replacement with substitute parts is manually calculated, requiring a large amount of inefficient load, which hinders enhancement of cost reduction and is a cause of loss of opportunity of cost reduction.

SUMMARY

An object of the present invention is to efficiently search for substitute parts of a device to be designed, eliminating the requirement for manual operation.

In addition to the above object, effects that the best mode to carry out invention to be detailed below and that the prior technique cannot reach can be regarded as object of the present invention.

The part information providing system of the embodiment includes a part information database that stores part information including a price of a first part and identification information of a second part, which serves as a substitute for the first part and which is cheaper in price than the first part, in association with identification of the first part; a retrieving section that retrieves identification information of a third part, which is a component of a device, from the part information database and, if the identification information of the third part is associated with the identification information of the second part, retrieves the second part, which serves as a substitute for the third part and which is cheaper in price than the third part, from the part information database using the identification information of the second part by following a link of the identification information of the second part; and a notifying section that notifies a user of information about the second part retrieved by the retrieving section.

The part information providing apparatus of the embodiment provides a user with part information from the part information database and includes the retrieving section and the notifying section.

Furthermore, the part information providing program instructs a computer to function of providing a user with part information from the part information database and more specifically instructs the computer to function as the retrieving section and the notifying section.

The technique disclosed herein can efficiently search for substitute parts of a device to be designed, not depending on manual operation.

The object and advantages of the embodiment will be realized and attained by means of the elements and combinations particularly pointed out in the claims.

It is to be understood that both the foregoing general description and the following detailed description are exemplary and explanatory and are not restrictive of the embodiment, as claimed.

BRIEF DESCRIPTION OF THE DRAWINGS

Fig. 1 is a block diagram schematically illustrating a functional configuration of a part information providing system according to a first embodiment of the present invention;

Fig. 2 is a diagram illustrating an example of a component part list of a device to be designed which list is obtained by a CAD system;

Fig. 3 is a diagram depicting an example of part information stored in a part information database;

Fig. 4 is a diagram illustrating an example of circuit information stored in a circuit information database;

Fig. 5 is a diagram depicting an example of production plan information stored in a production plan database;

Fig. 6 is a diagram illustrating information stored in a cost-reduction effect database;

Fig. 7 is a diagram illustrating an example of sort-displaying of information stored in a cost-reduction effect database;

Fig. 8 is a diagram illustrating operation of a part information providing system of the first embodiment; and

Figs. 9 and 10 are flow diagrams illustrating a succession of procedural steps of operation of a part information providing system of the first embodiment.

DESCRIPTION OF THE PREFERRED EMBODIMENTS

Hereinafter, a first embodiment of the present invention will now be described with reference to the accompanying drawings.

(1) configuration and function of a part information providing system:

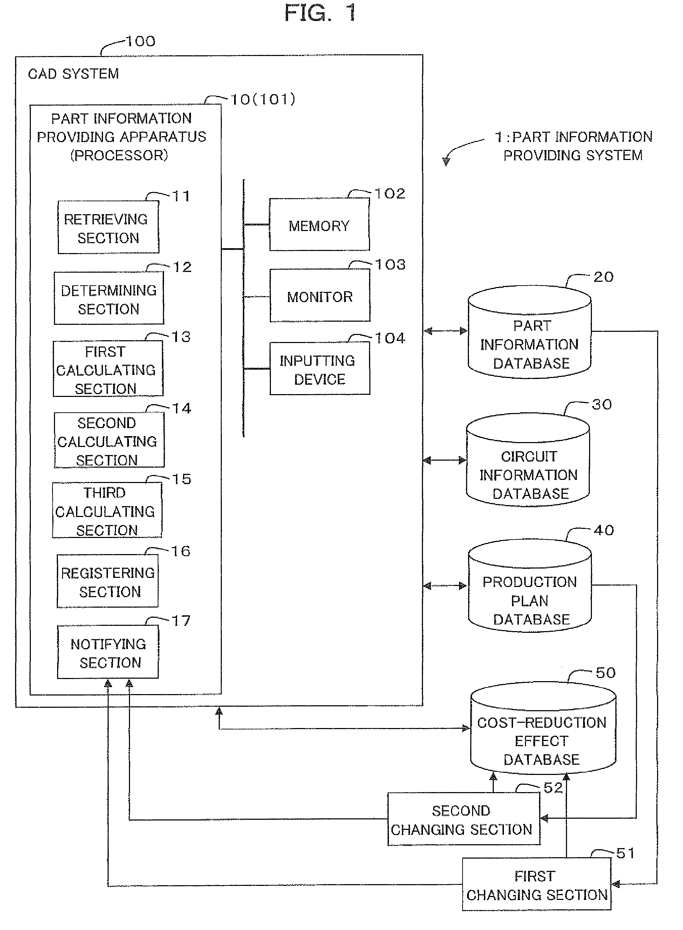

Fig. 1 is a block diagram schematically illustrating the functional configuration of a part information providing system 1. As depicted in Fig. 1, the part information providing system 1 is used in conjunction with a CAD(Computer Aided Design) system 100 that designs electric devices such as computers and mobile phones. The CAD system 100 includes a processor (CPU, Central Processing Unit) 101, a memory 102, a monitor 103, and an inputting device 104. In addition to the CAD function, the processor 101 serves, through executing a part information providing program stored in the memory 102, to function as a part information providing apparatus 10 that provides a user such as the designer with information about component parts constituting a device that the CAD system 100 is to design. The part information providing system 1 includes the part information providing apparatus 10 realized by the processor 101, and a part information database 20, a circuit information database 30, a production plane database 40, and a cost-reduction effect database 50 that are united with the CAD system 100.

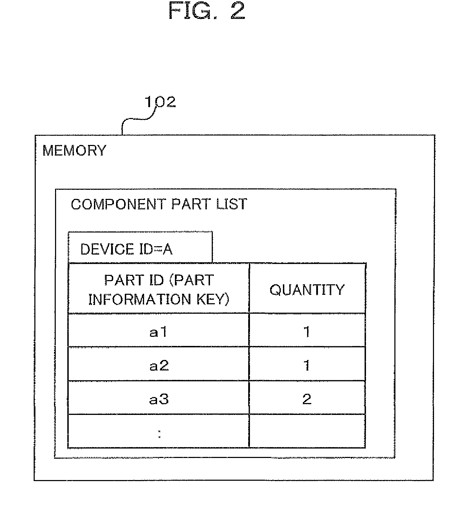

The memory 102 stores data to be used for various processes such as the part information providing program and a component part list of a device to be designed which list is obtained by the CAD function (see Fig. 2). The component part list includes part identification information that specifies the component parts selected when the CAD system 100 designs the device, and is stored in the memory 102 in association with the device identification information (ID=A) that specifies the device to be designed. Hereinafter, the identification information of a part is represented by a "part ID" or a "part information key", and the identification information of a device is represented by a "device ID".

Fig. 2 is a diagram illustrating an example of a component part list of a device to be designed which list is obtained by the CAD system 100. The component part list of Fig. 2 depicts that a single device to be designed and having a device ID=A consists of one component part having a part ID=al, one component part having a part ID=a2, two component parts having a part ID=a3,.... Hereinafter, the device to be designed and having an device ID=A is also referred to as the device A to be designed or simply device A, and the component part having a part ID=a1 is also referred to as the part a1.

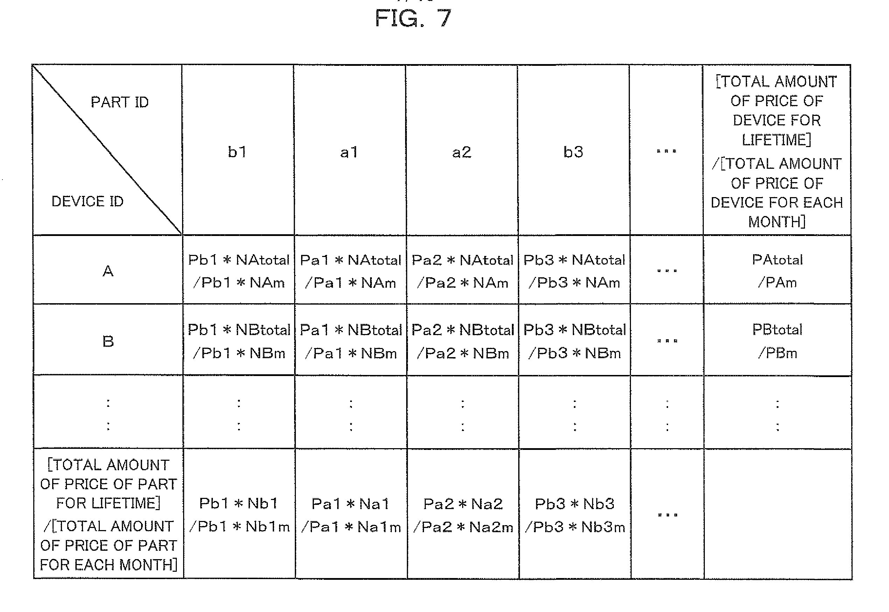

The memory 102 may be an internal storing device, such as a RAM (Random Access Memory), a ROM (Read Only Memory), a HDD (Hard Disk Drive), or an SSD (Solid State Drive), or an external storing device. The monitor 103 is a display such as a CRT (Cathode Ray Tube) or an LCD (Liquid Crystal Display), and is used for notification from a notifying section 17 that is to be detailed below to the user and for sort-displaying that is to be detailed below with reference to Fig. 7. The inputting device 104 is a keyboard, a mouse, and other devices operated by the user, and inputs various instructions from the user into the CPU 101 (part information providing apparatus 10). The inputting device 104 is used by the user for designing a device and selecting parts with reference to the monitor 103.

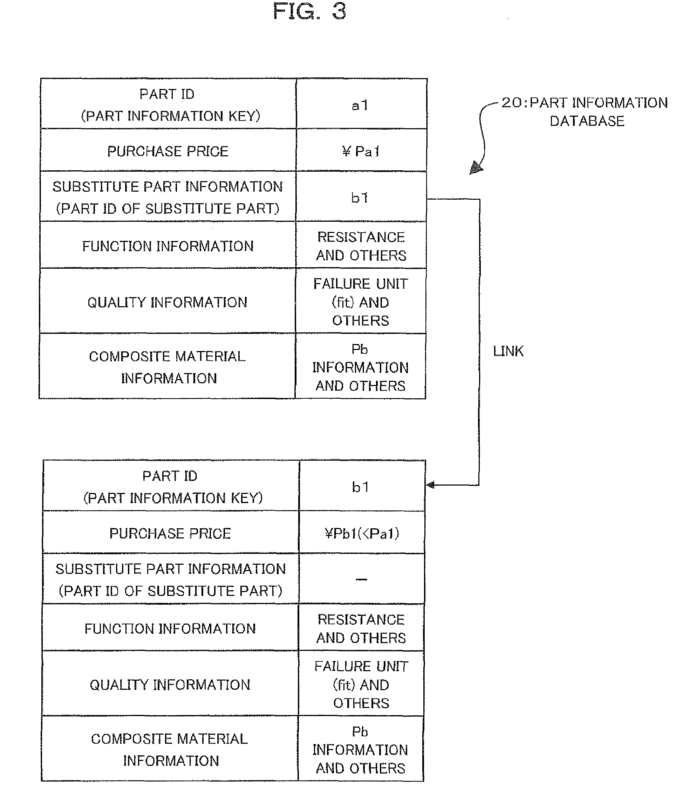

The part information database 20 stores part information in which information about parts frequently used for various devices to be designed, such as computers and mobile phones, are associated with the respective part IDs. The part information includes purchase price, substitute part information, function information, quality information, and composite material information of each part (see Fig. 3).

A substitute part of a part is cheaper in price than the part and can substitute for the part (in other words, can serve the same function as the part). If a part has a corresponding substitute part, the part ID of the substitute part is associated with the part ID of the part and registered as the substitute part information into the part information database 20. The function information concerns the function of parts. For example, if a part is a resistor, the resistance is registered as the function information. The quality information concerns the quality of parts and, for example, a failure rate (fit:failure unit) of each part is registered as the quality information. The component material information concerns material that parts contain, and, for example, includes information whether a part contains lead (Pb).

Fig. 3 is a diagram depicting an example of part information stored in the part information database 20. In the example of the part information of Fig. 3, information of a part having a part ID (part information key)=a1 includes the purchase price Pa1 yen, a part ID=b1 for substitute part information, function information, quality information, and composite material information. The registration of the part ID=b1 as the substitute part information indicates the existence of a part b1 that is cheaper than Pal yen of the part a1 and that can serve the same function as the part a1. As depicted in Fig. 3, registering the part ID=b1 in the substitute part information links part information of the part a1 to part information of the part b1. As the part information of the part b1, the purchase price Pb1 (<Pa1) yen, function information, quality information, and composite material information are registered. In the example of Fig. 3, since the substitute part information for the part b1 is not registered, a substitute part that is cheaper than part b1 and that can be substituted for the part b1 does not exist or is not found at that time.

Here, part information searched by designers that design various devices and also by a part adoption and management department are centralized in the part information database 20. More specifically, the part information database 20 is supplemented and updated by the designers of devices and by the part adoption and management department as required, so that the change in part information is reflected in the part information database 20. If a new part is found by searching, the part information of the new part is registered in the part information database 20 in association with the part ID of the new part. If the new part can be substitute for a part already registered in the part information database 20, the part ID of the new part is registered as the substitute part information for the already-registered part, so that the part information of the already-registered part is linked to the part information of the new part. Thereby, part information of a substitute part which serves the same function of a component part and which is the cheapest at that time can be obtained by following a link to the part ID of the substitute part. In the first embodiment, the part information database 20 which centralizes the part information containing substitute part information as the above is commonly used by device designers and the part adoption and management department.

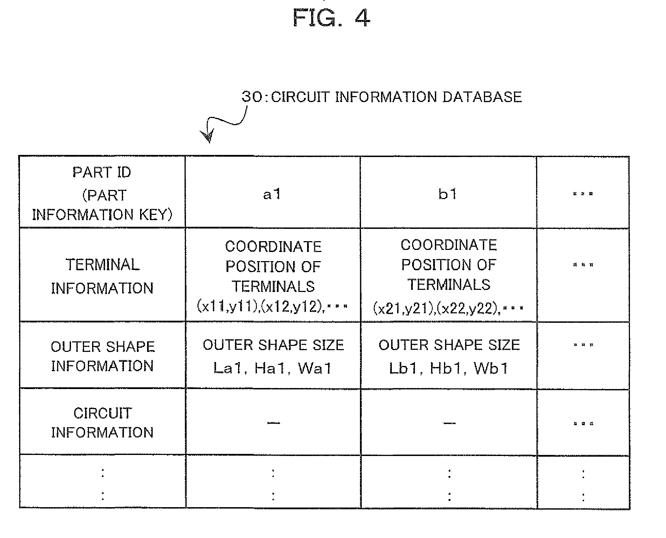

The circuit information database 30 stores circuit information about circuit parts constituting a device to be designed in association with the respective part IDs of the circuits parts. A circuit part is disposed on a board, has terminals, and is exemplified by an LSI chips. The circuit information includes terminal information, outer shape information, and circuit information of respective circuit parts (see Fig. 4). The terminal information includes positional coordinates of the respective terminals of a circuit part based on the coordinate of the origin. The outer shape information includes the length, the height, and the width of the outer shape of a circuit part. The circuit information includes information about the function of a circuit part. In the circuit information database 30, circuit information searched by designers that design various devices and also by a part adoption and management department are centralized likewise the part information database 20.

Fig. 4 illustrates an example of the circuit information stored in the circuit information database 30. In the example of the circuit information of Fig. 4, positional coordinates (x11, y11), (x12, y12), ... are registered in the terminal information of the circuit part a1; and the length La1, the height Ha1, and the width Wa1 are registered in the outer shape size of the same circuit part a1. In the same manner, positional coordinates (x21, y21), (x22, y22), ...are registered in the terminal information of the circuit part b1; and the length Lb1, the height Hb1, and the width Wb1 are registered in the outer shape size of the same circuit part b1.

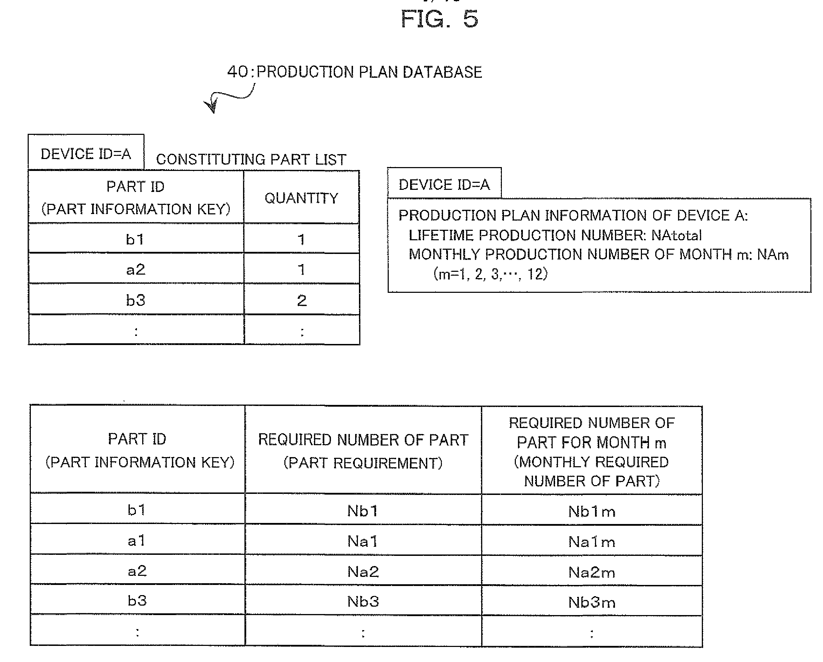

The production plan database 40 stores production plan information of a device to be designed in association with the device ID of the same device. The production plan database 40 includes a lifetime production number of a device to be designed, a production number of the device to be designed for each month, a required number (part requirement) of each part for the lifetime production number of the device, and a required number (monthly part requirement) of each part for each month (see Fig. 5). The production plan information of the production plan database 40 is managed by the production planning department, and is supplemented and updated according to requirement. Specifically, the production plan information is supplemented and updated according to the requirement by the production planning department, so that the change of the production plan is reflected in the production plan database 40.

Fig. 5 is a diagram depicting an example of the production plan information stored in the production plan database 40. In the example of the production plan information of Fig. 5, the component part list of a device A is registered, and the lifetime production number NAtotal and the production number NAm for month m (m=1, 2, ..., and 12) are stored as the production plan information of the device A. The component part list of the device A stored in the production plan database 40 has substituted parts replaced by the part information providing apparatus 10. Specifically, parts b1 and b3 in the component part list of the device A of Fig. 5 serve substituted for parts a1 and a3 in the component part list of the same device A of Fig. 2, respectively.

In the production plan database 40 of Fig. 5, part requirements and part requirements for each month of the parts b1, a1, a2, and b3 are registered in association with the respective part IDs. Specifically, the part requirement Nb1 and the part requirement Nb1m for each month of the part b1, the part requirement Na1 and the part requirement Na1m for each month of the part a1, the part requirement Na2 and the part requirement Na2m for each month of the part a2, and the part requirement Nb3 and the part requirement Nb3m for each month of the part b3 are registered.

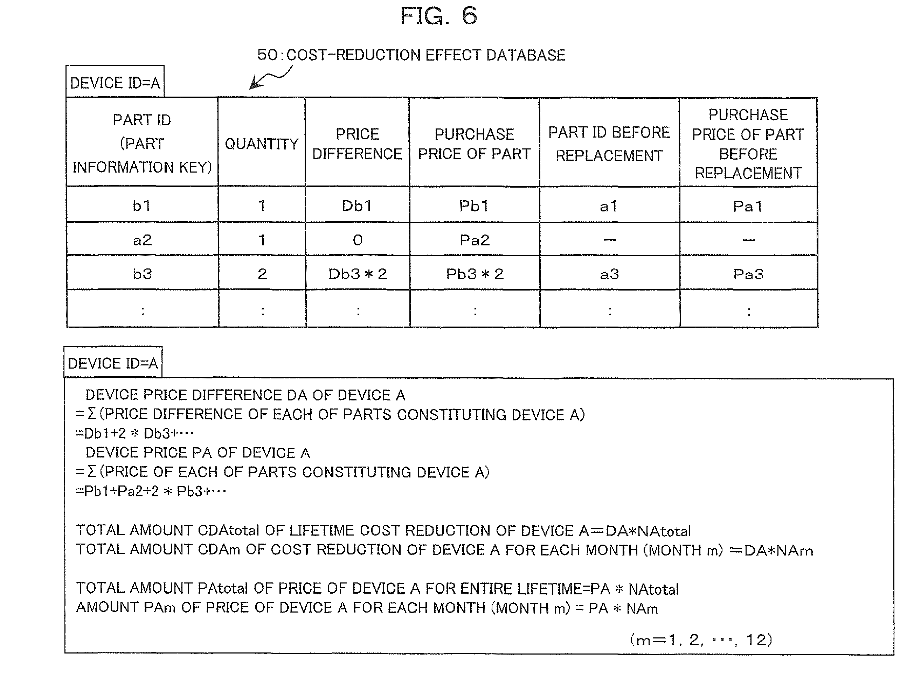

The cost-reduction effect database 50 is commonly used by various departments, and stores information of cost-reduction effect of a device to be designed which effect is calculated by calculating sections 14-16 to be detailed below in association with the device ID of the device. The information, such as cost-reduction effect, is registered into the cost-reduction effect database 50 by a registering section 16 to be detailed below, and is used for profit-and-loss calculation. The details of the information registered in the cost-reduction effect database 50 will be described below with reference to Fig. 6.

The processor 101 that functions as the part information providing apparatus 10 carries out the functions of a retrieving section 11, a determining section 12, a first calculating section 13, a second calculating section 14, a third calculating section 15, a registering section 16, and a notifying section 17 through executing the part information providing program. A processor (CPU, not illustrated) disposed alongside of the cost-reduction effect database 50 carries out the functions of a first changing section 51 and a second changing section 52 through executing a predetermined program.

The notifying section 17 notifies and provides various pieces of information obtained by the part information providing apparatus 10 to the user by means of images and voice via the monitor 103. Specific pieces of information will be described succession below.

The retrieving section 11 retrieves information of a component part from the part information database 20 using a part ID of a component part that the user assigns or a part ID that is selected from the component part list (see Fig. 2) stored in the memory 102 as a retrieving key. If a part ID of a substitute part is registered in the substitute part information of the retrieved part ID, the retrieving section 11 further retrieves the part ID of the substitute part from the part information database 20 and follows the link of the part ID of the substitute part. Thereby, the retrieving section 11 retrieves a part that serves as a substitute for the selected component part and that is the cheapest in price.

In the example of Fig. 3, as a result of retrieving a component part having a part ID=a1, a part ID=b1 is registered to be the substitute part information for the part a1. Then the retrieving section 11 follows the link of the part ID=b1 to retrieve the part b1. Since no substitute part information is registered in the part information of the part b1, the retrieving section 11 selects the part b1 as a substitute part for the part a1. The retrieving section 11 reads the part ID=b1, the price Pb1 yen of the substitute part b1, the function information, the quality information, and the composite material information of the part b1, and the price Pa1 of the part a1 from the part information database 20, and obtains the pieces of the read information as the result of the retrieval. Here, if the part information of the part a1 which is retrieved first has no registered substitute information, the retrieving section 11 reads the price Pa1 of the part a1, the function information, the quality information, and the composite material information of the part a1 from the part information database 20 and obtains the pieces of read information as the result of retrieval.

This function of the retrieving section 11 is included in the processor 101 of the CAD system 100. Alternatively, the part information database 20 may have the function of the retrieving section 11 and the processor 101 may send a part ID and a retrieval instruction to the retrieving section 11. The retrieving section 11 is realized, for example, a part retrieving API (Application Programming Interface). The part retrieving API receives a part ID, serving as a key, from the CAD system 100, and issues SQL (Structure Query Language) tor retrieval from the part information database 20 to the part information database 20, and receives the result of retrieval in relation to the issued SQL from the part information database 20.

If a selected component part to be retrieved is a circuit part such as an LSI chip and the retrieving section 11 retrieves the substitute part for the component part, the determining section 12 makes the following judgment by retrieving from and referring to the circuit information database 30. Here, description is made with reference to examples of Figs. 3 and 4. The determining section 12 retrieves the terminal information and the outer shape information of the part a1 from the circuit information database 30, using the part ID=a1 of the component part as a key. The determining section 12 further retrieves the terminal information and the outer shape information of the substitute part b1 from the circuit information database 30 using the part ID=b1 of the substitute part b1 retrieved by the retrieving section 11. The determining section 12 compares the positional coordinates of the terminals of the part a1 with the positional coordinates of the terminals of the substituted part b1 and determines whether the positions of all the terminals of the part a1 are the same or the substantially same as those of the substitute part b1. The determining section 12 further compares the outer shape (the length La1, the height Ha1, and the width Wa1) of the part a1 with the outer shape (the length Lb1, the height Hb1, and the width Wb1) of the substitute part b1, and determines whether the outer shape size of the substitute part b1 is equal to or less than the outer shape size of the part a1 (i.e., (Lb1≤La1, Hb1≤Ha1, and Wb<Wa1). A judgment as to whether the component part to be retrieved is a circuit part is made on the basis of the function information included in the part information.

If the determining section 12 determines that the positions of the terminals of the part a1 are the same as the positions of the terminals of the substitute part b1 and concurrently determines that the outer shape size of the substitute part b1 is equal to or less than the outer shape size of the part a1, the notifying section 17 notifies the user, via the monitor 103, that the part b1 is retrieved to be a substitute for the component part a1. At the same time, the notifying section 17 notifies the user of the function information, the quality information, and the composite material information of the substitute part b1 that the retrieving section 11 reads from the part information database 20 via the monitor 103.

In the first embodiment, the user determines whether the substitute part b1 satisfies desired criteria with reference to the function information, the quality information, and the composite material information of the substitute part b1 displayed on the monitor 103. If replacement of the component part a1 with the substitute part b1 is judged not to cause a problem, the user operates the inputting device 104 in order to instruct replacement with the substitute part b1. Following this instruction, the processor 101 replaces the part a1 in the component part list that the memory 102 stores with the substitute part b1. In the first embodiment, the user, such as a designer, determines whether the substitute part b1 satisfies desired criteria. Alternatively, the processor 101 may make the determination on the basis of the desired criteria and the function information, the quality information, and the composite material information of the substitute part b1.

When the retrieving section 11 retrieves the substitute part b1, the first calculating section 13 calculates the part price difference Db1(=Pa1-Pb1) between the price Pa1 of the component part a1 and the price Pb1 of the substitute part b1. The price Pa1 of the component part a1 and the price Pb1 of the substitute part b1 are obtained from the part information database 20 as the result of retrieval by the retrieving section 11. The notifying section 17 notifies the user of the part price difference Db1 calculated by the first calculating section 13 via the monitor 103.

The retrieving section 11 of the first embodiment retrieves a substitute part for each of all the component parts on the component part list. Each time a component part on the list is replaced with a retrieved substitute part, the first calculating section 13 calculates the part price difference of the component part and the substitute part, and the notifying section 17 notifies of the user of the calculated part price difference via the monitor 103.

The second calculating section 14 calculates the total of the part price differences, which the first calculating section 13 calculates for each of substitute parts, to be the device price difference of the entire device to be designed, and calculates the total price of the parts to constitute the device to be designed as the total price of the device. Here, description is made in relation to an example of calculating a device price difference and a device price assuming, as illustrating in Fig. 5, that the parts a1 and a3 of device A in the component part list of Fig. 2 are replaced by the substitute parts b1 and b3 while the part a2 is not replaced. In this case, the retrieval by the retrieving section 11 obtains the part price Pa1-Pa3, Pb1, and Pb3 of the parts a1-a3, b1, and b3, respectively. The calculation by the first calculating section 13 obtains the part price difference Db1 (=Pa1-Pb1) between the price of the part a1 and the price of the substitute part b1 and the part price difference Db3 (=Pa3-Pb3) between the price of the part a3 and the price of the substitute part b3. The second calculating section 14 calculates a device price difference DA representing an amount of cost reduction caused by replacing parts with the substitute parts in a single device A to be designed and a device price PA representing the total cost of a single device A to be designed according to the following formulae. The notifying section 17 notifies the user of the device price difference DA and the device price PA calculated by the second calculating section 14 via the monitor 103. Throughout the specification and the accompanying drawings, the symbol "*(asterisk) represents multiplication.

Device price difference DA of the device A=Σ (price difference of each of parts constituting the device A) =Db1+2*Db3+...

Device price PA of the device A=Σ(price of each of parts constituting the device A)=Pb1+Pa2+2*Pb3+...

The third calculating section 15 calculates, on the basis of the production plan information of a device to be designed which plan is stored in the production plan database 40 and of the device price difference calculated by the second calculating section 14, a prospective amount of cost reduction on the assumption that the device is manufactured using substitute parts for the respective component parts according to the production plan information. In addition, the third calculating section 15 calculates, on the basis of the production plan information of the device to be designed which plan is stored in the production plan database 40 and of the device price calculated by the second calculating section 14, a total price of the device manufactured according to the production plan information. Here, description is made in relation to an example of calculating the prospective amount of cost reduction and the total price of the device according to the production plan stored in the production plan database 40 of Fig. 5.

In this case, the total amount CDAtotal of lifetime cost reduction of device A is calculated on the basis of the device price difference DA of the device A calculated by the second calculating section 14 and of the lifetime production number NAtotal of the device A included in the production plan information according to the following formula.

$$CDAtotal = DA*NAtotal$$

The total amount CDAm of cost reduction of the device A for each month (month m) is calculated on the basis of the device price difference DA of the device A calculated by the second calculating section 14 and of the production number Nam of the device A for each month included in the production plan information according to the following formula.

$$\rule{3cm}{0.3cm}$$

Similarly, the total amount PAtotal of the price of the device A for the entire lifetime is calculated on the basis of the device price PA of the device A calculated by the second calculating section 14 and of the lifetime production number NAtotal of the device A included in the production plan information according to the following formula.

$$\rule{3cm}{0.3cm}$$

The total amount Pam of the price of device A for each month (month m) is calculated on the basis of the device price PA of the device A calculated by the second calculating section 14 and of the production number NAm of the device A for each month (month m) included in the production plan information according to the following formula.

$$PAm = PA*NAm$$

The notifying section 17 notifies the user of the total amount CDAtotal of lifetime cost reduction of device A, the total amount CDAm of cost reduction of the device A for each month (month m), the total amount PAtotal of the price of the device A for the entire lifetime, and the total total amount PAm of the price of device A for each month (month m), which are calculated by the third calculating section 15 as described above, via the monitor 103.

The registering section 16 registers, as cost-reduction effect, various pieces information retrieved, obtained, or calculated by the part information providing apparatus 10 into the cost-reduction effect database 50 in association with the device ID of a device to be designed. For example, as illustrated in Fig. 6, the registering section 16 registers, as the cost-reduction effect, the following pieces (1) through (7) of information into the cost-reduction effect database 50 in association with the device ID or the part ID.

(1) the component part list after replacement with the substitute parts b1 and b3;
(2) the part price difference calculated by the first calculating section 13 (associated with the part ID of each corresponding substitute part);
(3) the purchase price of each part retrieved by the retrieving section 11 (associated with the part ID);
(4) the purchase price of each part before replacement retrieved by the retrieving section 11 (associated with the part ID before the replacement);
(5) the production plan (NAtotal, NAm) of the device A obtained from the production plan database 40;
(6) the device price difference DA of the device A and the device price PA of the device A calculated by the second calculating section 14; and
(7) the total amount CDAtotal of lifetime cost reduction of device A, the total amount CDAm of cost reduction of the device A for each month (month m), the total amount PAtotal of the price of the device A for the entire lifetime, and the total total amount PAm of the price of device A for each month (month m) calculated by the third calculating section 15.

When the part information of the part information database 20 is changed, the first changing section 51 changes the cost-reduction effect in the cost-reduction effect database 50 in accordance with the details of the change. The first changing section 51 accesses the part information database 20 at a proper timing (e.g., at regular intervals) to detect the presence of change in the part information database 20. Alternatively, when the part information of the part information database 20 is changed, the first changing section 51 may receive a notification of the details of the change from the part information database 20. Upon detection of change or receipt of a notification of change, the first changing section 51 retrieves cost-reduction effect of a part related to the change from the cost-reduction effect database 50 using the part ID of the part. On the basis of the result of the retrieval and the details of the change and price fluctuation, the first changing section 51 re-calculates factors (e.g., the device price of the device, the price difference, the amount of lifetime cost reduction, the amount of cost reduction for each month, the total amount of price for entire lifetime, and the total amount of price for each month) of cost-reduction effect in the cost-reduction effect database 50 related to the change and price fluctuation, and updates the cost-reduction effect database 50 with the recalculated factors. The notifying section 17 notifies the user of the cost-reduction effect changed by the first changing section 51.

When the production plan information of the production plan database 40 is changed, the second changing section 52 changes the cost-reduction effect of the cost-reduction effect database 50 in accordance with the change. The second changing section 52 accesses the production plan database 40 at a proper timing (e.g., at regular intervals) to detect the presence of change in the production plan database 40. Alternatively, when the production plan information of the production plan database 40 is changed, the second changing section 52 may receive a notification of the details of the change from the production plan database 40. Upon detection of change or receipt of a notification of change, the second changing section 52 retrieves cost-reduction effect of a device related to the change from the cost-reduction effect database 50 using the device ID of the device. On the basis of the result of the retrieval and the details of the change, the second changing section 52 re-calculates factors (e.g., the amount of lifetime cost reduction, the amount of cost reduction for each month, the total amount of price for entire lifetime, and the total amount of price for each month) of cost-reduction effect in the cost-reduction effect database 50 related to the change, and updates the cost-reduction effect database 50 with the recalculated factors. The notifying section 17 notifies the user of the cost-reduction effect changed by the second changing section 52.

The notifying section 17 may have functions of: notifying, when the part information of the part information database 20 is changed, the user of the details of the change; and notifying, when the production plan information of the production plan database 40 is changed, the user of the details of the change. Furthermore, the notifying section 17 may have a function of notifying, when information of a new substitute part is registered into the part information database 20, the user of the registration.

The part information providing apparatus 10 (the notifying section 17) may notify the user of the details of the change (e.g., in amount of cost-reduction effect or amount of cost reduction) in the cost-reduction effect database 50 by means of e-mails or others.

As illustrated in Fig. 7, the part information providing apparatus 10 (the processor 101) may have a function of sorting information stored in the cost-reduction effect database 50 and displaying the sorted information on the monitor 103. Fig. 7 illustrates an example of the sort-displaying, in which device IDs=A, B,... are set in the vertical direction and part IDs= b1, a1, a2, b3, ... are set in the horizontal direction. In the grid at the intersection of the device A and the part b1, the total amount Pb1*NAtotal of the price of the part b1 used in the device A for the entire lifetime and the total amount Pb1*NAm of the price of the part b1 for each month are depicted. In the grids at the right end along the vertical direction, the total amount PAtotal of the price of each device A (B,...) for the entire lifetime and the total amount PAm of the price of each device for each month are depicted. Besides, in the grids at the bottom along the horizontal direction, the total amount Pb1*Nb1 of the price of each part b1 (a1, a2, b3, ...) for the entire lifetime and the total amount Pb1*Nb1m of the price of each part for each month are depicted. Under this displaying state, the user can arrange the sort-displaying in various orders, for example, in order of higher or lower price by operating the inputting device 104.) In Fig. 7, NBtotal represents the production number of the device B for the entire lifetime included in the production plan information; NBm represents the production number of the device B for each month (month m) included in the production plan information; PBtotal is the total amount of the price of the device B for the entire lifetime; and PBm represents the total mount of price of the device B for each month. Sort-displaying of Fig. 7 is based on the total amount of price for the entire lifetime and the total amount of the price for each month, but may alternatively based on the amount of cost reduction.

(2) operation of the part information providing system:

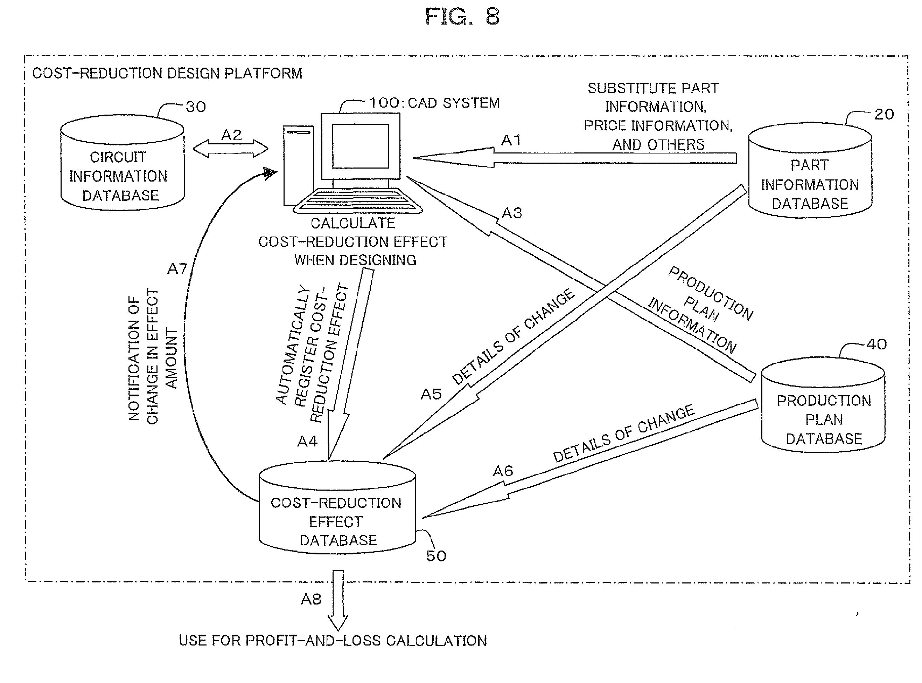

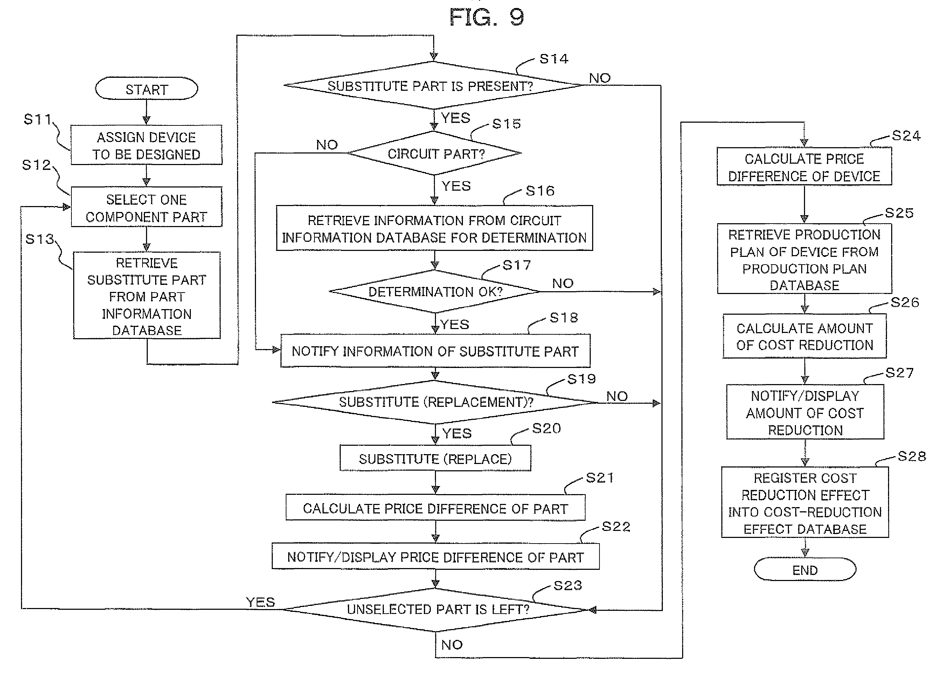

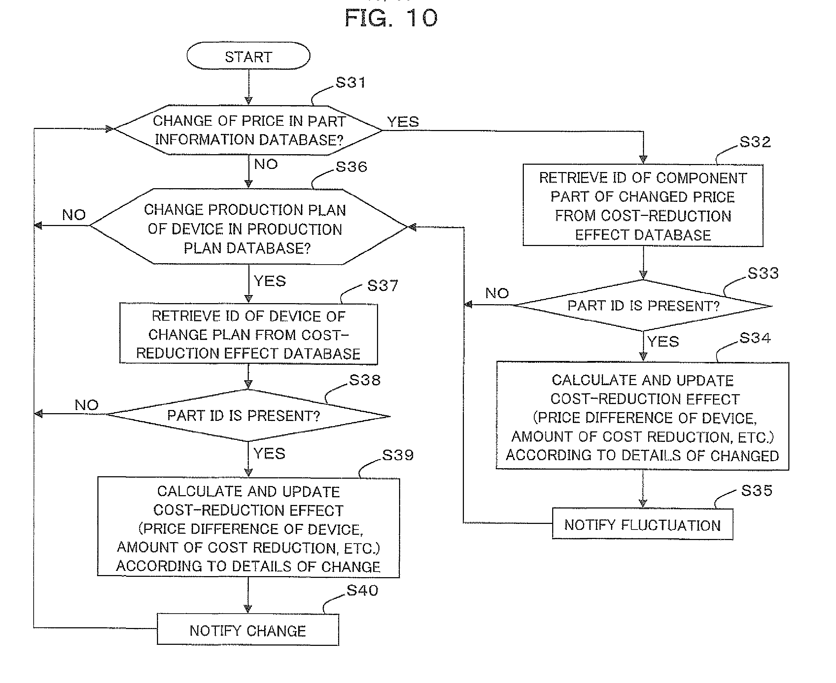

Next, specific operation of the part information providing system 1 of the first embodiment having the above configuration will now be described with reference to Figs. 8-10. Fig. 8 is a diagram illustrating operation of the part information providing system 1 according to the first embodiment; Fig. 9 is a flow diagram illustrating operation of the part information providing system 1 of the first embodiment, especially operation of the part information providing apparatus 10; and Fig. 10 is a flow diagram illustrating operation of the part information providing system 1 of the first embodiment, especially operations of the first changing section 51 and the second changing section 52 disposed alongside of the cost-reduction effect database 50.

For the beginning, description will now be made in relation to operation (steps S11-S28 of Fig. 9) of the part information providing apparatus 10 functioning on the CAD system 100 (the processor 101) with reference to Fig. 8.

The user such as the designer assigns the device ID of a device to be designed and specifies the component part list (see Fig. 2) associated with the assigned device ID (step S11). The user or the retrieving section 11 selects one component part from the component part list (step S12) and retrieves a substitute part for the component part from the part information database 20 (see Fig. 3) using the part ID of the selected component part as a key (step S13).

If the retrieving section 11 retrieves a part which serves as a substitute function for the component part and which is cheaper in price than the component part (YES route of step S14, see Fig. 3 and Arrow A1 of Fig. 8), the determining section 12 determines, on the basis of the function information of the component part and the substituted part, whether the component part and the substituted part are circuit parts (step S15).

If the component part and the substituted part are circuit parts (YES route of step S15), the determining section 12 retrieves the terminal information and the outer shape information of the component part from the circuit information database 30 using the part ID of the component part as a key (see Arrow A2 in Fig. 8). The determining section 12 further retrieves the terminal information and the outer shape information of the substitute part retrieved by the retrieving section 11 from the circuit information database 30 using the part ID of the substitute part (see Arrow A2 in Fig. 8). Then the determining section 12 compares the positional coordinates of the terminals of the component part with the positional coordinates of the terminals of the substitute part, and thereby determines whether all the terminals of the component part are the same in position as those of the substitute part. Furthermore, the determining section 12 compares the outer shape of the component part with the outer shape of the substitute part, and thereby determines whether the outer shape of the substitute part b1 is equal to or less than the outer shape of the component part a1 (step S16).

If the determining section 12 determines that all the terminals of the component part are the same in position as those of the substitute part and concurrently the outer shape of the substitute part is equal to or less than the outer shape of the component part (YES route in step S17), the notifying section 17 notifies the user, via the monitor 103, that the substitute part for the component part is retrieved (step S18). At the same time, the notifying section 17 notifies the user, via the monitor 103, of the function information, the quality information, and the composite material information of the substitute part that the retrieving section 11 reads from the part information database 20 (step S18, see Arrow A1 of Fig. 8).

The user refers to the function information, the quality information, and the composite material information of the substitute part displayed on the monitor 103, and determines whether the substitute part satisfies the desired criteria (step S19). If the user determines that replacement of the component part with the substitute part causes no problem, the user instructs the replacement with the substitute part via the inputting device 104 (YES route in step S19). Responding to the instruction, the processor 101 replaces the component part on the component part list stored in the memory 102 with the substitute part (step S20).

After the component part on the component part list is replaced with the substitute part, the first calculating section 13 calculates the part price difference between the price of the component part and that of the substitute part (step S21), which is notified to the user via the monitor 103 by the notifying section 17 (step S22).

If the component part and the substituted part are not circuit parts (NO route of step S15), the processor 101 skips steps S16 and S17 and proceeds to step S18. If the retrieving section 11 finds no part that serves as the substitute for the component part as the result of the retrieval (NO route of step S14), the processor 101 skips steps S15 through S22 and proceeds to steps step S23. If the determining section 12 does not determine that all the terminals of the component part are the same in position as those of the substitute part or that the outer shape of the substitute part is equal to or less than the outer shape of the component part (NO route in step S17), the processor 101 skips steps S18-S22 and proceeds to step S23. If the user does not determine in step S19 that the component part is replaced with the substitute part (NO route), the processor 101 skips steps S20-S22 and proceeds to step S23.

After that, if an unselected component part that is not assigned yet is present at the component part list (YES route of step S23), the procedure returns to step S12, so that steps S13-S23 are carried out after the user or the retrieving section 11 selects one component part from the component part list. Repeating steps S12-S23 for each component part accomplishes retrieval and search for a substitute part for each of the component parts constituting a device assigned in step S11. The component part list in which component parts are replaced with possible substitute parts is stored in the memory 102 and also in the production plan database 40 (see Fig. 5).

Upon accomplishment of retrieval and search for substitute parts for all the component parts (NO route in step S23), the second calculating section 14 calculates the device price difference of the entire device to be designed by totaling the part price differences that the first calculating section 13 calculates for the respective substitute parts (step S24). At the same time, the second calculating section 14 calculates the total price of the parts constituting the device to be designed as the total price of the device.

Then the part information providing apparatus 10 retrieves the production plan information of the device to be designed from the production plan database 40 using the device ID of the device and reads the retrieved production plan from the production plan database 40 (step S25, see Arrow A3 in Fig. 8).

In succession, on the basis of the production plan information of the device to be designed stored in the production plan database 40 and of the device price difference calculated by the second calculating section 14, the third calculating section 15 calculates an amount of lifetime cost reduction and an amount of cost reduction for each month when the device is manufactured using substitute parts for respective component parts according to the production plan information (step S26). At the same time, on the basis of the production plan information of the device to be designed stored in the production plan database 40 and of the total amount of price of the device calculated by the second calculating section 14, the third calculating section 15 calculates the total amount of price of the device when the device is manufactured according to the production plan information.

The device price difference and the total amount of price of the device calculated by the second calculating section 14, and the amount of lifetime cost reduction and the amount of cost reduction for each month calculated by the third calculating section 15 are notified to the user via the monitor 103 by the notifying section 17 (step S27). Besides, the device price difference and the total amount of price of the device calculated by the second calculating section 14, and the amount of lifetime cost reduction and the amount of cost reduction for each month calculated by the third calculating section 15 are registered as the cost reduction effect into the cost-reduction effect database 50, in association with the device ID of the device to be designed, by the registering section 16 (step S28, see Fig. 6 and Arrow A4 in Fig. 8).

Next, description will now be made in relation to operation (steps S31-S40 of flow diagram Fig. 10) of the first changing section 51 and the second changing section 52 arranged alongside of the cost-reduction effect database 50 with reference to Fig. 8.

Upon detection of price fluctuation in the part information database 20 or receipt of notification of the price fluctuation (YES route in step S31, see Arrow A5 in Fig. 8), the first changing section 51 retrieves the part ID related to the price fluctuation from the cost-reduction effect database 50 (step S32). If the retrieval finds the part ID in the cost-reduction effect database 50 (YES route in step S33), the first changing section 51 re-calculates factors (e.g., the device price difference, the price difference, the amount of lifetime cost reduction, the amount of cost reduction for each month, the total amount of price for entire lifetime, and the total amount of price for each month) of cost-reduction effect in the cost-reduction effect database 50 related to the change and price fluctuation on the basis of the result of retrieval and the details of the change and the price fluctuation, and changes the cost-reduction effect database 50 with the recalculated factors (step S34).

The cost-reduction effect changed by the first changing section 51 is notified to the user via the monitor 103 by the notifying section 17 (step S35, see Arrow A7 in Fig. 8). After step S35, the processor 101 proceeds to step S36. If the part ID is not found in the cost-reduction effect database 50 as the result of the retrieval (NO route in step S33), the processor 101 skips steps S34 and S35 and proceeds to step S36.

Upon detection of change in the production plan information of the production plan database 40 or receipt of notification of the change (YES route in step S36, see Arrow A6 of Fig. 8), the second changing section 52 retrieves the device ID of a device related to the change from the cost-reduction effect database 50 (step S37). If the retrieval finds the device ID (YES route in step S38), the second changing section 52 re-calculates factors (e.g., the amount of lifetime cost reduction, the amount of cost reduction for each month, the total amount of price for entire lifetime, and the total amount of price for each month) of cost-reduction effect in the cost-reduction effect database 50 related to the change on the basis of the result of retrieval and the details of the change and changes the cost-reduction effect database 50 with the recalculated factors (step S39).

The cost-reduction effect changed by the second changing section 52 is notified to the user via the monitor 103 by the notifying section 17 (step S40, see Arrow A7 in Fig. 8). After step S40, the processor 101 proceeds to step S31. If the device ID is not found (NO route in step S38), the processor 101 skips steps S39 and S40 and proceeds to step S31.

(3) effects of the part information providing system:

According to the first embodiment, in designing electric devices such as computers and mobile phones, the part information database 20 that stores purchase prices of component parts, the production plan database 40 that stores production plan information of the device to be designed, and the CAD system 100 are united with one another, which allows the CAD system 100 to select cheaper substitute parts. The amounts of cost reduction for the entire lifetime and for each month can be easily calculated and notified to the designer, so that the designer can design devices at low costs on the CAD system 100.

In particular, the part information database 20 is centralizedly managed and is commonly shared by device designers and the device design department. The part information searched by the respective designers and by the part adoption and management department is centralized in the part information database 20. Parts frequently used are registered in the part information database 20 and information of cheaper parts serve as substitute for the registered parts are also stored. This configuration of the part information database 20 allows the retrieving section 11 to find, as a result of retrieval of a component part from the part information database 20, a substitute part that serves as a substitute for the component part and that is cheaper in price than the component part. If a substitute part for the component part exists, the CAD system 100 can employ the substitute part, which can eliminate manual search of the designer in person for cheaper substitute parts each time of designing a device. Consequently, designers can design devices at low costs.

Before a cheaper substitute part is recommended to the designer, the determining section 12 accesses the circuit information database 30 and obtains the terminal information and the outer shape information of both the component part and the substitute part. If the determining section 12 determines that all the terminals of the component part are the same in position as those of the substitute part and concurrently the outer shape of the substitute part is equal to or less than the outer shape of the component part, information about the substitute part is notified to the designer, so that the substitute part is employed. In other words, the determining section 12 determines the substitute part can practically and physically substitute for the component part, and if the result of the determination is positive, the substitute part is employed.

If a cheaper substitute part is selected, the first calculating section 13 calculates the price difference between the use of the component part and the use of the substitute part, and the calculated price difference is displayed on the monitor 103 of the CAD system 100. If two or more component parts of a single device to be designed are replaced with respective corresponding substitute parts, the second calculating section 14 calculates a device price difference (i.e., the total amount of cost reduction) per device and the calculated device price difference is displayed on the monitor 103. Thereby, the designer can design the device at low costs, confirming the cost-reduction effect derived by replacing component parts with substitute parts.

The third calculating section 15 refers to the future prospective production numbers of the device (for the entire lifetime and for each month) stored in the production plan database 40, based on which the third calculating section 15 calculates the total amount of lifetime cost reduction, the amount of cost reduction for each month, the amount of cost reduction for each year, and others that are to be displayed on the monitor 103 of CAD system 100. Thereby, the designer can design the device at low costs, confirming the cost-reduction effect derived by replacing component parts with substitute parts.

The various pieces of information, such as price information, production plan information, and the results of calculations in the first through the third calculating sections 13-15, are registered into the cost-reduction effect database 50 by the registering section 16. The cost-reduction effect database 50 is united through the first changing section 51 and the second changing section 52 with the part information database 20 and the production plan database 40. Accordingly, in the event of price fluctuation or change in a production plan, prices related to the cost-reduction effect registered in the cost-reduction effect database 50 is automatically changed by the first changing section 51 and the second changing section 52. Besides, the details of the fluctuation and the change are notified to the designers by the notifying section 17. Therefore, when price is fluctuated or the production plan is changed, the designers can soon grasp the change in price related to the cost-reduction effect accompanied by the fluctuation or the change.

When the part price stored in the part information database 20 is fluctuated, when the production plan in the production plan database 40 is changed, or when another substitute part is supplemented to the part information database 20, the notifying section 17 notifies the fluctuation, the change and the supplement to the designers via the monitor 103 or e-mails. Thereby, the designers can soon grasp the price fluctuation of a part, change in production plan, and a supplemented substituted part, and consider the fluctuation the change and the supplement into low-cost designing of the devices.

As described above with reference to Fig. 7, the monitor 103 sort-displays information stored in the cost-reduction effect database 50. In other words the designer can refer to information sorted in various orders assigned by the designer, such as orders of higher price and lower price, on the monitor 103. Thereby, the designers can effectively use the information stored in the cost-reduction effect database 50 for low-cost designing and also for profit-and-loss calculation (see Arrow A8 in Fig. 8).

As detailed above, the part information database 20, the circuit information database 30, the production plan database 40, and the cost-reduction effect database 50 are united with one another and also with the CAD system 100. These databases 20-50 are united by the use of a common part ID (part information key) that identifies each part and of a common device ID that identifies each device to be designed. In other words, the databases 20-50 are retrieved using common part IDs and common device IDs as keys.

As detailed above, in the first embodiment, cheaper substitute parts constituting a device to be designed are efficiently searched, not requiring manual operation by designers.

The databases 20-50 and the CAD system 100 are articulately united with one another, and are collectively formed into a cost-reduction design platform (see Fig. 8) shared by various departments. With this configuration, search for substitute parts and complex calculation of amounts of cost reduction that have been redundantly carried out by designers and designing departments can be carried out efficiently, and additionally, information (i.e., the cost-reduction effect) registered in the cost-reduction effect database 50 can be visualized on the CAD system 100. Such efficient search and calculation and visualization further encourage the effort for cost reduction and reduce the loss of opportunity for cost reduction.

(4) others:

A preferred embodiment of the present invention is described as the above, but the present invention should by no means be limited to the above embodiment. Various changes and modifications can be suggested without departing from the gist of the present invention.

Part or the entire function of the retrieving section 11, the determining section 12, the first calculating section 13, the second calculating section 14, the third calculating section 15, the registering section 16, the notifying section 17, the first changing section 51, and the second changing section 52 is realized by a computer (including CPU, information processor, various terminals) executing a predetermined application program (part information providing program).

The program is provided in the form of being stored in a non-transitory computer-readable recording medium such as flexible disk, CD (e.g., CD-ROM, CD-R, and CD-RW), a DVD (DVD-ROM, DVD-RAM, DVD-R, DVD-RW, DVD+R, DVD+RW), Blu-ray disk. The computer reads the program from the recording medium and sends the program to an internal or external memory to store for use.

Here, a computer is a concept of a combination of hardware and an OS (Operating System) and means hardware which operates under control of the OS. Otherwise, if an application program independently operates hardware not requiring an OS, the hardware itself corresponds to the computer. Hardware includes at least a microprocessor such as a CPU and means to read a computer program recorded in a recording medium. The part information providing program includes a program code that causes the above computer to realize the functions of the above sections 11-17, 51, and 52. Alternatively, part of the function may be realized by the OS, not by application program.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment has been described in detail, it should be understood that the various changes, substitutions, and alterations could be made hereto without departing from the spirit and scope of the invention.

**Claims**

1. A part information providing system comprising:

   a part information database that stores part information including a price of a first part and identification information of a second part, which serves as a substitute for the first part and which is cheaper in price than the first part, in association with identification of the first part;
   a retrieving section that retrieves identification information of a third part, which is a component of a device, from the part information database and, if the identification information of the third part is associated with the identification information of the second part, retrieves the second part, which serves as a substitute for the third part and which is cheaper in price than the third part, from the part information database using the identification information of the second part by following a link of the identification information of the second part; and

   a notifying section that notifies a user of information about the second part retrieved by the retrieving section.

2. The part information providing system according to claim 1, wherein:

   the part information database stores the part information in which function information, quality information, and composite material information of the first part and the second part are associated with the identification information of the first part and the second part, respectively; and
   the notifying section reads, as the information about the second part retrieved by the retrieving section, the function information, the quality information, and the composite material information of the second part from the part information database and notifies the user of the function information, the quality information, and the composite material information of the second part.

3. The part information providing system according to claim 1 or 2, further comprising a determining section that determines, if the third part is a circuit part that is to be mounted to a board and that has terminals, whether the second part retrieved by the retrieving section has terminals the same in position as those of the third part and has an outer shape size equal to or less than that of the third part, wherein
   if the determining section determines that the second part retrieved by the retrieving section has terminals the same in position as those of the third part and has an outer shape size equal to or less than that of the third part, the notifying section notifies the user of the information about the second part.

4. The part information providing system according to claim 3, further comprising a circuit information database that stores circuit information including terminal information and outer shape information of the circuit part in association with identification information of the circuit part, wherein
   the determining section determines, on the basis of the terminal information and the outer shape information retrieved from the circuit information database using the identification information of the third part and of the terminal information and the outer shape information retrieved from the circuit information database using the identification information of the second part, whether the second part retrieved by the retrieving section has terminals the same in position as those of the third part and has an outer shape size equal to or less than that of the third part.

5. The part information providing system according to one of claims 1-4, further comprising a first calculating section that calculates a part price difference between the price of the third part read from the part information database and the price of the second part read from the part information database, wherein
the notifying section notifies the user of the part price difference calculated by the first calculating section.

6. The part information providing system according to claim 5, wherein:

the retrieving section retrieves a plurality of the second parts that serve as substitutes for a plurality of the third parts constituting the device;
the first calculating section calculates a plurality of the part price differences one between the price of each of the plurality of third parts read from the part information database and the price of the corresponding second part read from the part information database;
the part information providing system further comprises a second calculating section that calculates a total of the plurality of part price differences calculated by the first calculating section as a total price difference of the device; and
the notifying section notifies the user of the total price difference calculated by the second calculating section.

7. The part information providing system according to claim 6, further comprising:

a production plan database that stores production plan information of the device; and
a third calculating section that calculates, on the basis of the production plan information stored in the production plan database and of the total price difference calculated by the second calculating section, a prospective amount of cost reduction on the assumption that the device is manufactured using the plurality of second parts as substitutes for the third parts according to the production plan information, wherein
the notifying section notifies the user of the prospective amount of cost reduction calculated by the third calculating section.

8. The part information providing system according to claim 7, further comprising:

a cost-reduction effect database that stores cost-reduction effect of the device; and
a registering section that registers, as the cost-reduction effect, the total price difference calculated by the second calculating section and the prospective amount of cost reduction calculated by the third calculating section in association with the identification information of the plurality of third parts, the identification information of the plurality of second parts, and identification information of the device, in the cost-reduction effect database.

9. The part information providing system according to one of claims 1-8, wherein the part information in the part information database is supplemented and updated as required so that change of the part information is reflected in the part information database.

10. The part information providing system according to claim 9, wherein, when the part information in the part information database is changed, the notifying section notifies the user of details of the change of the part information.

11. The part information providing system according to claim 8, wherein:

the part information in the part information database is supplemented and updated as required so that change of the part information is reflected in the part information database; and
the part information providing system further comprises a first changing section that changes, when the part information in the part information database is changed, the cost-reduction effect in the cost-reduction effect database in accordance with details of the change of the part information.

12. The part information providing system according to claim 11, wherein the notification section notifies the user of the cost-reduction effect changing by the first changing section.

13. The part information providing system according to one of claims 1-10, wherein the production plan information in the production plan database is supplemented and updated as required so that change of the production plan is reflected in the production plan database.

14. The part information providing system according to claim 13, wherein, when the production plan information in the production plan information database is changed, the notifying section notifies the user of details of the change of the production plan information.

15. A part information providing system according to one of claims 8, 11, and 12, wherein:

the production plan information in the production plan information database is supplemented and updated as required so that change of the production plan information is reflected in the production plan information database; and

the part information providing system further comprises a second changing section that changes, when the production plan information in the production plan information database is changed, the cost-reduction effect in the cost-reduction effect database in accordance with details of the change of the production plan information.

16. A part information providing system according to claim 15, wherein the notifying section notifies the user of the cost-reduction effects changed by the second changing section.

17. A part information providing apparatus that provides a user with part information from a part information database that stores the part information including a price of a first part and identification information of a second part, which serves as a substitute for the first part and which is cheaper in price than the first part, in association with identification of the first part, the part information providing apparatus comprising:

a retrieving section that retrieves identification information of a third part, which is a component of a device, from the part information database and, if the identification information of the third part is associated with the identification information of the second part, retrieves the second part, which serves as a substitute for the third part and which is cheaper in price than the third part, from the part information database using the identification information of the second part by following a link of the identification information of the second part; and

a notifying section that notifies a user of information about the second part retrieved by the retrieving section.

18. The part information providing apparatus according to claim 17, further comprising a calculating section that calculates a part price difference between the price of the third part read from the part information database and the price of the second part read from the part information database, wherein the notifying section notifies the user of the part price difference calculated by the calculating section.

19. A part information providing program that instructs a computer to function of providing a user with part information from a part information database that stores the part information including a price of a first part and identification information of a second part, which serves as a substitute for the first part and which is cheaper in price than the first part, in association with identification of the first part, wherein the program instructs the computer to function as:

a retrieving section that retrieves identification information of a third part, which is a component of a device, from the part information database and, if the identification information of the third part is associated with the identification information of the second part, retrieves the second part, which serves as a substitute for the third part and which is cheaper in price than the third part, from the part information database using the identification information of the second part by following a link of the identification information of the second part; and

a notifying section that notifies a user of information about the second part retrieved by the retrieving section.

20. The part information providing program according to claim 19, wherein

the program instructs the computer to further function as a calculating section that calculates a part price difference between the price of the third part read from the part information database and the price of the second part read from the part information database, and

the notifying section notifies the user of the part price difference calculated by the calculating section.

# FIG. 1

# FIG. 2

102

**MEMORY**

**COMPONENT PART LIST**

DEVICE ID=A

| PART ID (PART INFORMATION KEY) | QUANTITY |
|---|---|
| a1 | 1 |
| a2 | 1 |
| a3 | 2 |
| : | |

# FIG. 3

| | | |
|---|---|---|
| PART ID (PART INFORMATION KEY) | a1 | |
| PURCHASE PRICE | ¥ Pa1 | |
| SUBSTITUTE PART INFORMATION (PART ID OF SUBSTITUTE PART) | b1 | |
| FUNCTION INFORMATION | RESISTANCE AND OTHERS | |
| QUALITY INFORMATION | FAILURE UNIT (fit) AND OTHERS | |
| COMPOSITE MATERIAL INFORMATION | Pb INFORMATION AND OTHERS | |

20:PART INFORMATION DATABASE

LINK

| | |
|---|---|
| PART ID (PART INFORMATION KEY) | b1 |
| PURCHASE PRICE | ¥Pb1(<Pa1) |
| SUBSTITUTE PART INFORMATION (PART ID OF SUBSTITUTE PART) | — |
| FUNCTION INFORMATION | RESISTANCE AND OTHERS |
| QUALITY INFORMATION | FAILURE UNIT (fit) AND OTHERS |
| COMPOSITE MATERIAL INFORMATION | Pb INFORMATION AND OTHERS |

## FIG. 4

30 : CIRCUIT INFORMATION DATABASE

| PART ID (PART INFORMATION KEY) | a1 | b1 | ... |
|---|---|---|---|
| TERMINAL INFORMATION | COORDINATE POSITION OF TERMINALS (x11,y11),(x12,y12),... | COORDINATE POSITION OF TERMINALS (x21,y21),(x22,y22),... | ... |
| OUTER SHAPE INFORMATION | OUTER SHAPE SIZE La1, Ha1, Wa1 | OUTER SHAPE SIZE Lb1, Hb1, Wb1 | ... |
| CIRCUIT INFORMATION | — | — | ... |
| ⋮ | ⋮ | ⋮ | ⋮ |

FIG. 5

40:PRODUCTION PLAN DATABASE

| DEVICE ID=A | CONSTITUTING PART LIST |
|---|---|

| PART ID (PART INFORMATION KEY) | QUANTITY |
|---|---|
| b1 | 1 |
| a2 | 1 |
| b3 | 2 |
| : | : |

DEVICE ID=A

PRODUCTION PLAN INFORMATION OF DEVICE A:
  LIFETIME PRODUCTION NUMBER: NAtotal
  MONTHLY PRODUCTION NUMBER OF MONTH m: NAm
    (m=1, 2, 3,···, 12)

| PART ID (PART INFORMATION KEY) | REQUIRED NUMBER OF PART (PART REQUIREMENT) | REQUIRED NUMBER OF PART FOR MONTH m (MONTHLY REQUIRED NUMBER OF PART) |
|---|---|---|
| b1 | Nb1 | Nb1m |
| a1 | Na1 | Na1m |
| a2 | Na2 | Na2m |
| b3 | Nb3 | Nb3m |
| : | : | : |

EP 2 442 242 A1

# FIG. 6

50:COST-REDUCTION EFFECT DATABASE

DEVICE ID=A

| PART ID (PART INFORMATION KEY) | QUANTITY | PRICE DIFFERENCE | PURCHASE PRICE OF PART | PART ID BEFORE REPLACEMENT | PURCHASE PRICE OF PART BEFORE REPLACEMENT |
|---|---|---|---|---|---|
| b1 | 1 | Db1 | Pb1 | a1 | Pa1 |
| a2 | 1 | 0 | Pa2 | — | — |
| b3 | 2 | Db3 * 2 | Pb3 * 2 | a3 | Pa3 |
| : | : | : | : | : | : |

DEVICE ID=A

DEVICE PRICE DIFFERENCE DA OF DEVICE A
= Σ (PRICE DIFFERENCE OF EACH OF PARTS CONSTITUTING DEVICE A)
=Db1+2 * Db3+···
DEVICE PRICE PA OF DEVICE A
= Σ (PRICE OF EACH OF PARTS CONSTITUTING DEVICE A)
=Pb1+Pa2+2 * Pb3+···

TOTAL AMOUNT CDAtotal OF LIFETIME COST REDUCTION OF DEVICE A=DA*NAtotal
TOTAL AMOUNT CDAm OF COST REDUCTION OF DEVICE A FOR EACH MONTH (MONTH m) =DA*NAm

TOTAL AMOUNT PAtotal OF PRICE OF DEVICE A FOR ENTIRE LIFETIME=PA * NAtotal
AMOUNT PAm OF PRICE OF DEVICE A FOR EACH MONTH (MONTH m) = PA * NAm

(m=1, 2, ···, 12)

EP 2 442 242 A1

FIG. 7

| PART ID / DEVICE ID | b1 | a1 | a2 | b3 | ... | [TOTAL AMOUNT OF PRICE OF DEVICE FOR LIFETIME] /[TOTAL AMOUNT OF PRICE OF DEVICE FOR EACH MONTH] |
|---|---|---|---|---|---|---|
| A | Pb1 * NAtotal /Pb1 * NAm | Pa1 * NAtotal /Pa1 * NAm | Pa2 * NAtotal /Pa2 * NAm | Pb3 * NAtotal /Pb3 * NAm | ... | PAtotal /PAm |
| B | Pb1 * NBtotal /Pb1 * NBm | Pa1 * NBtotal /Pa1 * NBm | Pa2 * NBtotal /Pa2 * NBm | Pb3 * NBtotal /Pb3 * NBm | ... | PBtotal /PBm |
| ⋮ | ⋮ | ⋮ | ⋮ | ⋮ | ⋮ | ⋮ |
| [TOTAL AMOUNT OF PRICE OF PART FOR LIFETIME] /[TOTAL AMOUNT OF PRICE OF PART FOR EACH MONTH] | Pb1 * Nb1 /Pb1 * Nb1m | Pa1 * Na1 /Pa1 * Na1m | Pa2 * Na2 /Pa2 * Na2m | Pb3 * Nb3 /Pb3 * Nb3m | ... | |

## FIG. 8

COST-REDUCTION DESIGN PLATFORM

100: CAD SYSTEM

20 — PART INFORMATION DATABASE

30 — CIRCUIT INFORMATION DATABASE

40 — PRODUCTION PLAN DATABASE

50 — COST-REDUCTION EFFECT DATABASE

SUBSTITUTE PART INFORMATION, PRICE INFORMATION, AND OTHERS

A1

A2

A3

PRODUCTION PLAN INFORMATION

A5 — DETAILS OF CHANGE

A6 — DETAILS OF CHANGE

CALCULATE COST-REDUCTION EFFECT WHEN DESIGNING

A4 — AUTOMATICALLY REGISTER COST-REDUCTION EFFECT

A7 — NOTIFICATION OF CHANGE IN EFFECT AMOUNT

A8 — USE FOR PROFIT-AND-LOSS CALCULATION

22

## FIG. 9

START

→ ASSIGN DEVICE TO BE DESIGNED (S11)

→ SELECT ONE COMPONENT PART (S12)

→ RETRIEVE SUBSTITUTE PART FROM PART INFORMATION DATABASE (S13)

→ SUBSTITUTE PART IS PRESENT? (S14) — NO → (to S23 path / S24)
- YES

→ CIRCUIT PART? (S15) — NO → S18
- YES

→ RETRIEVE INFORMATION FROM CIRCUIT INFORMATION DATABASE FOR DETERMINATION (S16)

→ DETERMINATION OK? (S17) — NO → (to S23)
- YES

→ NOTIFY INFORMATION OF SUBSTITUTE PART (S18)

→ SUBSTITUTE (REPLACEMENT)? (S19) — NO → (to S23)
- YES

→ SUBSTITUTE (REPLACE) (S20)

→ CALCULATE PRICE DIFFERENCE OF PART (S21)

→ NOTIFY/DISPLAY PRICE DIFFERENCE OF PART (S22)

→ UNSELECTED PART IS LEFT? (S23)
- YES → (back to S12)
- NO →

→ CALCULATE PRICE DIFFERENCE OF DEVICE (S24)

→ RETRIEVE PRODUCTION PLAN OF DEVICE FROM PRODUCTION PLAN DATABASE (S25)

→ CALCULATE AMOUNT OF COST REDUCTION (S26)

→ NOTIFY/DISPLAY AMOUNT OF COST REDUCTION (S27)

→ REGISTER COST REDUCTION EFFECT INTO COST-REDUCTION EFFECT DATABASE (S28)

→ END

## FIG. 10

```
                    ( START )
                        │
                        │ S31
                        ▼
         CHANGE OF PRICE IN PART ──── YES ─────────────────────┐
         INFORMATION DATABASE?                                 │
                        │                                      │ S32
                        │ NO         S36                       ▼
                        ▼                          RETRIEVE ID OF COMPONENT
    ┌── CHANGE PRODUCTION PLAN                     PART OF CHANGED PRICE
    NO  OF DEVICE IN PRODUCTION ◄──┐               FROM COST-REDUCTION
    │   PLAN DATABASE?             │               EFFECT DATABASE
    │           │                  │                         │
    │           │ YES      S37     │                         │ S33
    │           ▼                  │   NO                    ▼
    │  RETRIEVE ID OF DEVICE OF    └──◄── PART ID IS PRESENT?
    │  CHANGE PLAN FROM COST-                                │
    │  REDUCTION EFFECT DATABASE                             │ YES    S34
    │           │                                            ▼
    │           │ S38                          CALCULATE AND UPDATE
    │   NO      ▼                               COST-REDUCTION EFFECT
    │◄── PART ID IS PRESENT?                    (PRICE DIFFERENCE OF DEVICE,
    │           │                               AMOUNT OF COST REDUCTION, ETC.)
    │           │ YES      S39                  ACCORDING TO DETAILS OF CHANGED
    │           ▼                                            │
    │  CALCULATE AND UPDATE                                  │ S35
    │  COST-REDUCTION EFFECT                                 ▼
    │  (PRICE DIFFERENCE OF DEVICE,              NOTIFY FLUCTUATION
    │  AMOUNT OF COST REDUCTION, ETC.)
    │  ACCORDING TO DETAILS OF CHANGE
    │           │
    │           │ S40
    │           ▼
    └──  NOTIFY CHANGE
```

EP 2 442 242 A1

Europäisches
Patentamt

European
Patent Office

Office européen
des brevets

**EUROPEAN SEARCH REPORT**

Application Number

EP 11 18 1574

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2008 234101 A (CENTRAL JAPAN TECHNO SERVICE K) 2 October 2008 (2008-10-02) * abstract; figure 1 * ----- | 1-20 | INV. G06F17/30 G06Q10/00 |
| X | US 2005/125261 A1 (ADEGAN ALEXANDER O [US]) 9 June 2005 (2005-06-09) * abstract; figures 1,5,7b * * paragraph [0034] - paragraph [0049] * * paragraph [0067] * ----- | 1-20 | |
| X | US 2008/154755 A1 (LAMB III GILBERT C [US]) 26 June 2008 (2008-06-26) * the whole document * ----- | 1-20 | |
| X | US 7 343 212 B1 (BREARLEY QUENTIN STEWART [US] ET AL) 11 March 2008 (2008-03-11) * the whole document * ----- | 1-20 | |

TECHNICAL FIELDS
SEARCHED      (IPC)

G06F
G06Q

The present search report has been drawn up for all claims

| Place of search | Date of completion of the search | Examiner |
|---|---|---|
| Berlin | 10 January 2012 | Nazzaro, Antonio |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 11 18 1574

This annex lists the patent family members relating to the patent documents cited in the above-mentioned European search report.
The members are as contained in the European Patent Office EDP file on
The European Patent Office is in no way liable for these particulars which are merely given for the purpose of information.

10-01-2012

| Patent document cited in search report | | Publication date | Patent family member(s) | Publication date |
|---|---|---|---|---|
| JP 2008234101 | A | 02-10-2008 | NONE | |
| US 2005125261 | A1 | 09-06-2005 | NONE | |
| US 2008154755 | A1 | 26-06-2008 | NONE | |
| US 7343212 | B1 | 11-03-2008 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000113051 A
- JP 2001229193 A
- JP HEI5266106 B
- JP 2004234399 A
- JP 2004287951 A